# EUROPÄISCHE PATENTSCHRIFT

(11) **EP 3 389 156 B1**
(45) Veröffentlichungstag und Bekanntmachung des Hinweises auf die Patenterteilung: **02.06.2021**
(21) Anmeldenummer: 17166630.8
(22) Anmeldetag: 13.04.2017
(51) Int. Cl.: H02H 3/00, H02H 3/087, H02H 3/38, H02H 7/085, H02H 7/09, G01R 19/165, G01R 31/327, G01R 31/34

(54) **VERFAHREN ZUM BETREIBEN EINES ELEKTRISCHEN GARTEN- UND/ODER FORSTGERÄTESYSTEMS, SCHUTZELEKTRONIKSCHALTUNG, SCHUTZELEKTRONIKSCHALTUNGSSYSTEM, AKKUMULATORSYSTEM UND ELEKTRISCHES GARTEN- UND/ODER FORSTGERÄTESYSTEM**
METHOD FOR OPERATING AN ELECTRIC GARDEN AND/OR FORESTRY SYSTEM, SAFETY ELECTRONIC CIRCUIT, SAFETY ELECTRONIC CIRCUIT SYSTEM, STORAGE BATTERY SYSTEM AND ELECTRIC GARDEN AND/OR FORESTRY SYSTEM
PROCÉDÉ DE FONCTIONNEMENT D'UN SYSTÈME D'APPAREIL FORESTIER ET/OU DE JARDIN ÉLECTRIQUE, CIRCUIT ÉLECTRONIQUE DE PROTECTION, SYSTÈME DE CIRCUIT ÉLECTRONIQUE DE PROTECTION, SYSTÈME D'ACCUMULATEUR ET SYSTÈME D'APPAREIL FORESTIER ET/OU DE JARDIN ÉLECTRIQUE

(43) Veröffentlichungstag der Anmeldung: 17.10.2018
(73) Patentinhaber: Andreas Stihl AG & Co. KG, 71336 Waiblingen (DE)
(72) Erfinder: Gurr, Kay-Steffen, 74078 Heilbronn (DE); Heigemeyr, Christian, 85116 Egweil (DE); Mack, Andreas, 71409 Schwaikheim (DE); Schurr, Martin, 73557 Mutlangen (DE)
(74) Vertreter: Patentanwälte Ruff, Wilhelm, Beier, Dauster & Partner mbB

(56) Entgegenhaltungen:
- DE-A1- 19 743 234
- DE-A1-102012 103 551
- DE-A1-102013 214 726
- US-A1- 2005 140 327
- US-A1- 2009 284 877

## Beschreibung

### ANWENDUNGSGEBIET UND STAND DER TECHNIK

Die Erfindung bezieht sich auf ein Verfahren zum Betreiben eines elektrischen Garten- und/oder Forstgerätesystems, eine Schutzelektronikschaltung für ein elektrisches Garten- und/oder Forstgerätesystem, ein Schutzelektronikschaltungssystem mit einer solchen Schutzelektronikschaltung, ein Akkumulatorsystem mit einer solchen Schutzelektronikschaltung und ein elektrisches Garten- und/oder Forstgerätesystem mit einer solchen Schutzelektronikschaltung.

Ein Verfahren zum Betreiben eines elektrischen Garten- und/oder Forstgerätesystems, eine Schutzelektronikschaltung für ein elektrisches Garten- und/oder Forstgerätesystem und ein elektrisches Garten- und/oder Forstgerätesystem mit einer solchen Schutzelektronikschaltung sind bekannt.

Aus der US 2009/0284877 A1 ist ein Leistungs-Management-Modul für ein Windensystem aufweisend ein Überlastunterbrechungsmodul und ein Niederspannungsunterbrechungsmodul bekannt. Das Überlastunterbrechungsmodul bestimmt einen Betriebsstrom des Windensystems und liefert ein erstes Unterbrechungssignal, wenn der Strom größer als eine Stromgrenze ist. Gleichzeitig bestimmt das Niederspannungsunterbrechungsmodul eine Spannung einer Leistungsquelle, insbesondere einer Fahrzeugbatterie, und liefert ein zweites Unterbrechungssignal, wenn die Spannung niedriger als eine Spannungsgrenze ist. Ein Relais-Modul unterbricht den Betriebsstrom basierend auf dem ersten Unterbrechungssignal und/oder dem zweiten Unterbrechungssignal. Dies ermöglicht, dass die Batterie nach dem Windenbetrieb noch eine ausreichend hohe Spannung zum Starten eines Fahrzeugmotors hat.

Des Weiteren sind aus der DE 10 2012 103 551 A1, das den nächstliegenden Stand der Technik wiedergibt, eine elektronische Sicherungsvorrichtung und ein entsprechendes elektronisches Sicherungsverfahren bekannt. Die Sicherungsvorrichtung weist Eingangsanschlüsse auf, an denen eine elektrische Spannungsquelle angeschlossen ist. Am Ausgangsanschluss ist eine Last angeschlossen, deren anderer Anschluss beispielsweise an einer Klemme eines externen (oder zur Sicherungsvorrichtung gehörenden) Klemmblocks angeschlossen ist, an den auch der
Eingangsanschluss angeschlossen ist. Des Weiteren weist die Sicherungsvorrichtung eine steuerbare Schalteinrichtung auf, die in einer Verbindungsleitung zwischen dem Eingangsanschluss und dem Ausgangsanschluss angeordnet ist. Diese dient dazu, bei einem Auslösen der Sicherungsvorrichtung den Stromfluss von der Spannungsquelle zur Last zu unterbrechen. Zur Steuerung der Schalteinrichtung ist eine Steuereinheit vorgesehen. Die Steuereinheit erhält als Eingangssignale eine an dem Ausgangsanschluss (bzw. an der Last) anliegende Ausgangsspannung, die mittels einer Spannungsmesseinrichtung gemessen wird, und einen Ausgangsstrom, der mittels einer Strombestimmungseinrichtung bestimmt wird. Die Steuereinheit ist zur Steuerung des Sicherungsverfahrens ausgebildet. In einem ersten Schritt wird die Schalteinrichtung geschlossen, so dass ein Strom von der Quelle zur Last fließen kann. In einem zweiten Schritt wird der Ausgangsstrom bestimmt, um festzustellen, ob ein Kurzschlussfall vorliegt oder nicht. Bevorzugt wird dazu ein Vergleich mit einer Kurzschlussstromschwelle vorgenommen. Wenn im zweiten Schritt festgestellt wird, dass möglicherweise ein Kurzschluss vorliegt, wird anschließend die Schalteinrichtung wieder geöffnet. Dadurch fällt die Ausgangsspannung wieder ein Stück weit ab, wobei das Abfallen davon abhängt, ob es sich tatsächlich um einen Kurzschluss handelt oder ob die zur Feststellung des Kurzschlusses festgestellte Stromstärke des Ausgangsstroms nicht durch einen tatsächlichen Kurzschluss in der Last verursacht ist, sondern es sich um einen beim Einschalten der Schalteinrichtung auftretenden Stromimpuls handelt, der bei kapazitiven Lasten auftritt, wenn die zugeführte Spannung plötzlich sprunghaft ansteigt. Um dies festzustellen, wird in einem weiteren Schritt die momentane Ausgangsspannung bestimmt und anschließend mit einer vor dem letzten Öffnen der Schalteinrichtung gemessenen Ausgangsspannung verglichen. Die Differenz zwischen diesen beiden Ausgangsspannungen wird dabei gebildet und mit einem Spannungsschwellwert verglichen. Wenn dies der Fall ist, wird dies so interpretiert, dass kein echter Kurzschluss vorliegt. Deshalb wird anschließend der nächste Schaltvorgang vorgenommen, indem die Schalteinrichtung wieder geschlossen wird. Wenn festgestellt wird, dass die Differenzspannung unterhalb der vorgegebenen Spannungsschwelle liegt, wird dies so interpretiert, dass tatsächlich ein echter Kurzschluss vorliegt, so dass die Schalteinrichtung dauerhaft geöffnet bleibt.

### AUFGABE UND LÖSUNG

Der Erfindung liegt als Aufgabe die Bereitstellung eines Verfahrens zum Betreiben eines elektrischen Garten- und/oder Forstgerätesystems zugrunde, das verbesserte Eigenschaften aufweist, insbesondere mehr Funktionalitäten. Des Weiteren liegt der Erfindung als Aufgabe die Bereitstellung einer Schutzelektronikschaltung für ein elektrisches Garten- und/oder Forstgerätesystem, eines Schutzelektronikschaltungssystems mit einer solchen Schutzelektronikschaltung, eines Akkumulatorsystems mit einer solchen Schutzelektronikschaltung und eines elektrisches Garten- und/oder Forstgerätesystems mit einer solchen Schutzelektronikschaltung zugrunde.

Die Erfindung löst diese Aufgabe durch die Bereitstellung eines Verfahrens mit den Merkmalen des Anspruchs 1. Des Weiteren wird die der Erfindung zugrundeliegende Aufgabe durch eine Schutzelektronikschaltung mit den Merkmalen des Anspruchs 8, ein Schutzelektronikschaltungssystem mit den Merkmalen des Anspruchs 11, ein Akkumulatorsystem mit den Merkmalen des Anspruchs 12 und ein elektrisches Garten- und/oder Forstgerätesystem mit den Merkmalen des Anspruchs 13 gelöst. Vorteilhafte Weiterbildungen und/oder Ausgestaltungen der Erfindung sind in den abhängigen Ansprüchen beschrieben.

Das erfindungsgemäße Verfahren ist zum Betreiben eines elektrischen Garten- und/oder Forstgerätesystems ausgebildet. Das elektrische Garten- und/oder Forstgerätesystem weist einen Akkumulator, ein Garten- und/oder Forstgerät mit einem Elektromotor und eine Schutzelektronikschaltung auf. Die Schutzelektronikschaltung weist Eingänge, Ausgänge, ein Schaltelement und einen Bypasspfad auf. Die Eingänge, insbesondere Eingangsanschlüsse, sind an den Akkumulator angeschlossen, insbesondere elektrisch. Die Ausgänge, insbesondere Ausgangsanschlüsse, sind an das Garten- und/oder Forstgerät angeschlossen, insbesondere elektrisch. Das Schaltelement ist in einem Leistungspfad zwischen einem der Eingänge und einem der Ausgänge angeordnet, insbesondere elektrisch. Der Bypasspfad ist in dem Leistungspfad parallel zu dem Schaltelement geschaltet und weist ein Strombegrenzungswiderstandselement auf. Das Verfahren weist die Schritte auf: a) Anschalten des Schaltelements in einen ersten Leitungszustand. b) Messen eines elektrischen Stroms durch den Leistungspfad. c) Abschalten des Schaltelements in einen, insbesondere von dem ersten Leitungszustand verschiedenen, zweiten Leitungszustand, der als Sperrzustand bezeichnet werden kann, falls der gemessene elektrische Strom einen vorgegebenen Stromgrenzwert überschreitet. d) Messen einer elektrischen Ausgangsspannung zwischen den Ausgängen. e1) Entweder Wiederanschalten des Schaltelements in den ersten Leitungszustand, falls die gemessene elektrische Ausgangsspannung einen vorgegeben Spannungsgrenzwert erreicht und/oder überschreitet. e2) Oder beziehungsweise alternativ zu Schritt e1) Ausgeben eines Fehlersignals, insbesondere eines Kurzschlusssignals, falls die gemessene elektrische Ausgangsspannung den vorgegeben Spannungsgrenzwert unterschreitet.

Neueste Entwicklungen und Technologien führen zu immer niederinduktiven und niederohmschen Akkumulatoren, insbesondere bei Lithium-Ionen-Akkumulatoren. Eine Folge davon sind sehr kurze Stromanstiegszeiten, insbesondere kleiner als 50 Mikrosekunden (µs) für 350 Ampere (A), und ein sehr hoher elektrischer Strom im Kurzschlussfall, insbesondere bis zu 900 A.

Insbesondere kann das Garten- und/oder Forstgerät eine Motorelektronikschaltung für den Elektromotor aufweisen, welche mindestens einen Zwischenkreiskondensator und/oder mindestens ein Motorschaltelement aufweisen kann, wobei der Zwischenkreiskondensator und/oder das Motorschaltelement an die Ausgänge der Schutzelektronikschaltung und an den Elektromotor angeschlossen sein können/kann, insbesondere elektrisch. Insbesondere kann der Zwischenkreiskondensator einen Elektrolytkondensator aufweisen. Insbesondere kann das Motorschaltelement einen Brücken-Transistor aufweisen.

Das Verfahren ermöglicht, das Garten- und/oder Forstgerät vor einem Überstrom zu schützen, insbesondere dessen Motorelektronikschaltung, soweit vorhanden, und/oder den Strom durch den Leistungspfad auf ein Maß zu deckeln, welches das Motorschaltelement, soweit vorhanden, noch zuverlässig schalten kann. Insbesondere kann das Verfahren ermöglichen, für das Motorschaltelement die Safe Operating Area (SOA) einzuhalten. Insbesondere kann das Verfahren ermöglichen, eine Stromhöhe beim Laden des Zwischenkreiskondensators, soweit vorhanden, zu begrenzen.

Zusätzlich ermöglicht das Verfahren einen Überstrom aufgrund eines elektrischen Kurzschlusses von einem Überstrom zu unterscheiden, welcher insbesondere von einer relativ geringen Inneninduktivität und/oder einem relativ geringen Innenwiderstand des Akkumulators verursacht werden kann. Bei Überschreitung des Stromgrenzwerts wird das Schaltelement abgeschaltet. Eine Unterscheidung zwischen einem Kurzschlussfall und einem Normalbetrieb, insbesondere einem Laden des Zwischenkreiskondensators, soweit vorhanden, kann nicht allein mittels des Kriteriums "Stromhöhe" möglich sein, insbesondere nicht bei Verwendung eines Akkumulators neuerer Bauart. Durch das weitere Kriterium "Ausgangsspannungshöhe" kann eine Unterscheidung zwischen einem Kurzschlussfall und einem Normalbetrieb erfolgen. Sinkt die Ausgangsspannung nach Erkennung einer Überschreitung des Stromgrenzwerts unter den Spannungsgrenzwert so liegt ein Kurzschluss vor, ansonsten ist es Normalbetrieb.

Insbesondere kann der Akkumulator als ein auswechselbarer Akkumulator ausgebildet sein. Somit kann nicht ausgeschlossen werden, dass in dem elektrische Garten- und/oder Forstgerätesystem ein Akkumulator älterer Bauart verwendet werden kann. Das Verfahren kann sowohl mit einem Akkumulator älterer Bauart als auch neuerer Bauart kompatibel sein. Insbesondere kann in allen Betriebsfällen ein elektrischer Strom größer als der Stromgrenzwert verhindert werden, unabhängig davon, ob die Speisung mittels eines älteren oder neueren Akkumulators erfolgt.

Insbesondere kann ein ohmscher Widerstand des Leistungspfads von einem ohmschen Widerstand des Schaltelements, wenn dieses in seinen ersten Leitungszustand angeschaltet ist, bestimmt und/oder dominiert sein. Dies kann ermöglichen, dass der Zwischenkreiskondensator, soweit vorhanden, möglichst schnell geladen werden kann.

Insbesondere kann der Schritt b) zeitgleich und/oder zeitlich nach dem Schritt a) ausgeführt werden, insbesondere kann der Schritt b) zeitlich dauerhaft ausgeführt werden. Insbesondere kann der Schritt c) zeitgleich und/oder zeitlich nach dem Schritt b) ausgeführt werden. Insbesondere kann der Schritt d) zeitgleich und/oder zeitlich nach dem Schritt b) und/oder c) ausgeführt werden, insbesondere kann der Schritt d) zeitlich dauerhaft ausgeführt werden. Insbesondere kann der Schritt e1) zeitgleich und/oder zeitlich nach dem Schritt c) und/oder d) ausgeführt werden. Insbesondere kann der Schritt e2) zeitgleich und/oder zeitlich nach dem Schritt c) und/oder d) ausgeführt werden.

Das Fehlersignal kann insbesondere akustisch, optisch und/oder haptisch ausgegeben werden. Zusätzlich kann im Schritt e2) das Schaltelement in dem zweiten Leitungszustand behalten, gehalten und/oder belassen werden.

Insbesondere kann das Verfahren automatisch ausgeführt werden. In anderen Worten kann das Verfahren ohne menschlichen Eingriff ausgeführt werden.

In einer Weiterbildung der Erfindung liegt der vorgegebene Stromgrenzwert in einem Bereich von 200 A bis 500 A. Insbesondere kann der Stromgrenzwert in einem Bereich von 300 A bis 400 A liegen, insbesondere kann der Stromgrenzwert 350 A sein. Somit kann der Stromgrenzwert über einem Stromwert in einem Dauerbetrieb und/oder Toogle-Betrieb, beispielsweise von 50 A bis 100 A, liegen. Zusätzlich oder alternativ stellt der Akkumulator eine Eingangsspannung mit einem Eingangsspannungswert zwischen den Eingängen bereit und der vorgegebene Spannungsgrenzwert ist von dem Eingangsspannungswert abhängig. Insbesondere kann der Spannungsgrenzwert der halbe Eingangsspannungswert sein. Sinkt die Ausgangsspannung nach Erkennung einer Überschreitung des Stromgrenzwerts unter die halbe Eingangsspannung beziehungsweise unter die vorige halbe Ausgangsspannung so liegt ein Kurzschluss vor, ansonsten ist es Normalbetrieb.

In einer Weiterbildung der Erfindung wird der Schritt e1) in einem Bereich von 0,5 Millisekunden (ms) = 500 µs bis 10 ms nach dem Schritt c) ausgeführt. Dieser Zeitbereich kann für einen Benutzer unmerklich sein und/oder für elektrische Bauelemente des elektrische Garten- und/oder Forstgerätesystems erträglich sein. Insbesondere kann der Schritt e1) in einem Bereich von 0,5 ms bis 5 ms, insbesondere in einem Bereich von 0,5 ms bis 2 ms, insbesondere 1 ms, nach dem Schritt c) ausgeführt werden.

In einer Weiterbildung werden die Schritte b) bis e1) wiederholt. Dies kann gewährleisten, dass bei einem erneuten Überschreiten des elektrischen Stroms von dem vorgegebenen Stromgrenzwert das Schaltelement in seinen zweiten Leitungszustand abgeschaltet werden kann. Insbesondere können die Schritte b) bis e1) mehrfach wiederholt werden, insbesondere mindestens 10 mal ausgeführt werden. Falls der elektrische Strom weiterhin den vorgegebenen Stromgrenzwert überschreitet, kann das Schaltelement in seinen zweiten Leitungszustand abgeschaltet werden, in dem zweiten Leitungszustand behalten werden und das Fehlersignal ausgegeben werden.

In einer Weiterbildung der Erfindung weist das Schaltelement einen Feldeffekttransistor (FET) auf, insbesondere einen Metall-Oxid-Halbleiter-Feldeffekttransistor (MOSFET). Der Feldeffekttransistor wird an einer Steuerelektrode mit einer Steuerspannung zum Anschalten in seinen ersten Leitungszustand und zum Abschalten in seinen zweiten Leitungszustand beaufschlagt. Der Schritt c) weist auf: Erzeugen der Steuerspannung derart, dass kein Avalancheeffekt auftritt. Dies kann ein Beschädigen des Schaltelements während des Abschaltens verringern oder verhindern. Insbesondere kann der Schritt c) aufweisen: Schalten des Schaltelements, insbesondere zuerst, in einen Linearbetrieb, der als dritter Leitungszustand zwischen dem ersten Leitungszustand und dem zweiten Leitungszustand bezeichnet werden kann, und, insbesondere anschließend, Abschalten des Schaltelements in seinen zweiten Leitungszustand. Insbesondere kann die Steuerspannung in Abhängigkeit von einer Schaltspannung des Feldeffekttransistors erzeugt werden. Die Schaltspannung kann eine am Feldeffekttransistor über eine Drain-Source-Strecke abfallende Spannung sein.

In einer Weiterbildung der Erfindung weist das Verfahren die Schritte auf: Messen eines ersten elektrischen Spannungsabfalls an dem Schaltelement, wenn das Schaltelement in seinen ersten Leitungszustand angeschaltet ist. Messen eines zweiten elektrischen Spannungsabfalls an dem Schaltelement, wenn das Schaltelement in seinen zweiten Leitungszustand abgeschaltet ist. Bestimmen einer ordnungsgemäßen Funktion des Schaltelements in Abhängigkeit von einer Differenz zwischen dem zweiten elektrischen Spannungsabfall und dem ersten elektrischen Spannungsabfall. Die Differenzmessung kann ermöglichen, Absolutmessfehler in der Messgenauigkeit zu eliminieren. Falls das Schaltelement nicht ordnungsgemäß funktioniert, kann insbesondere ein Fehlersignal ausgegeben werden. Der erste Spannungsabfall und der zweite Spannungsabfalls können insbesondere mittels Messen der Eingangsspannung, Messen der Ausgangsspannung und Bilden einer Differenz zwischen der Eingangsspannung und der Ausgangsspannung gemessen werden.

In einer Weiterbildung der Erfindung weist das Verfahren die Schritte auf: Bereitstellen einer, insbesondere vorgegebenen, elektrischen Mindestleistung von dem Akkumulator an den Ausgängen, auch wenn das Schaltelement in den zweiten Leitungszustand abgeschaltet ist. Ausführen eines Selbsttests des Garten- und/oder Forstgeräts unter Verwendung der bereitgestellten elektrischen Mindestleistung. Dies kann ein Bestimmen einer ordnungsgemäßen Funktion der Motorelektronikschaltung, soweit vorhanden, ermöglichen. Insbesondere braucht der Elektromotor dabei nicht betrieben zu werden.

Des Weiteren bezieht sich die Erfindung auf eine Schutzelektronikschaltung für ein elektrisches Garten- und/oder Forstgerätesystem, insbesondere zum Ausführen des zuvor beschriebenen Verfahrens. Die erfindungsgemäße Schutzelektronikschaltung weist Eingänge, Ausgänge, ein Schaltelement, eine Strommesseinrichtung, eine Spannungsmesseinrichtung, eine Ausgabeeinrichtung und eine Steuereinheit auf. Die Eingänge sind zum Anschließen an einen Akkumulator ausgebildet. Die Ausgänge sind zum Anschließen an ein Garten- und/oder Forstgerät mit einem Elektromotor ausgebildet. Das Schaltelement ist in einem Leistungspfad zwischen einem der Eingänge und einem der Ausgänge angeordnet. Die Strommesseinrichtung ist zum Messen eines elektrischen Stroms durch den Leistungspfad ausgebildet. Die Spannungsmesseinrichtung ist zum Messen einer elektrischen Ausgangsspannung zwischen den Ausgängen ausgebildet. Die Ausgabeeinrichtung ist zum Ausgeben eines Fehlersignals ausgebildet. Die Steuereinheit ist zum Zusammenwirken mit dem Schaltelement, der Strommesseinrichtung, der Spannungsmesseinrichtung und der Ausgabeeinrichtung ausgebildet. Des Weiteren ist die Steuereinheit zum Anschalten des Schaltelements in einen ersten Leitungszustand, zum Abschalten des Schaltelements in einen zweiten Leitungszustand, falls der gemessene elektrische Strom einen vorgegebenen Stromgrenzwert überschreitet, zum Wiederanschalten des Schaltelements in den ersten Leitungszustand, falls die gemessene elektrische Ausgangsspannung eine vorgegeben Spannungsgrenzwert erreicht und/oder überschreitet, und zum Aktivieren der Ausgabeeinrichtung zum Ausgeben des Fehlersignals ausgebildet, falls die gemessene elektrische Ausgangsspannung den vorgegeben Spannungsgrenzwert unterschreitet.

Die Schutzelektronikschaltung ermöglicht, das Garten- und/oder Forstgerät vor einem Überstrom zu schützen, insbesondere dessen Motorelektronikschaltung, soweit vorhanden, und/oder den Strom durch den Leistungspfad auf ein Maß zu deckeln, welches das Motorschaltelement, soweit vorhanden, noch zuverlässig schalten kann. Zusätzlich ermöglicht die Schutzelektronikschaltung einen Überstrom aufgrund eines Kurzschlusses von einem Überstrom zu unterscheiden, welcher insbesondere von einer relativ geringen Inneninduktivität und/oder einem relativ geringen Innenwiderstand des Akkumulators verursacht werden kann.

Die Schutzelektronikschaltung kann sowohl mit einem Akkumulator älterer Bauart als auch neuerer Bauart kompatibel sein. Insbesondere kann in allen Betriebsfällen ein elektrischer Strom größer als der Stromgrenzwert verhindert werden, unabhängig davon, ob die Speisung mittels eines älteren oder neueren Akkumulators erfolgt.

Insbesondere kann die Schutzelektronikschaltung zum Ausführen des zuvor beschriebenen Verfahrens ausgebildet sein. Insbesondere kann die Ausgabeeinrichtung einen Summer und/oder Buzzer, einen Lautsprecher, eine Anzeige, insbesondere eine LED, und/oder eine Vibrationseinrichtung aufweisen.

Die Schutzelektronikschaltung weist einen Bypasspfad auf. Der Bypasspfad ist in dem Leistungspfad parallel zu dem Schaltelement geschaltet und weist ein Strombegrenzungswiderstandselement auf. Dies kann ermöglichen, den Strom zu begrenzen, insbesondere wenn das Schaltelement in seinen zweiten Leitungszustand abgeschaltet ist. Insbesondere kann der ohmsche Widerstand des Leistungspfads von dem ohmschen Widerstand des Schaltelements, wenn dieses in seinen ersten Leitungszustand angeschaltet ist, bestimmt und/oder dominiert sein. Insbesondere kann der ohmsche Widerstand des Leistungspfads von einem ohmschen Widerstand des Strombegrenzungswiderstandselements, wenn das Schaltelement in seinen zweiten Leitungszustand abgeschaltet ist, bestimmt und/oder dominiert sein. Insbesondere kann der ohmsche Widerstand des Schaltelements, wenn dieses in seinen ersten Leitungszustand angeschaltet ist, relativ kleiner als der ohmsche Widerstand des Strombegrenzungswiderstandselements sein. Insbesondere kann der ohmsche Widerstand des Schaltelements, wenn dieses in seinen zweiten Leitungszustand abgeschaltet ist, relativ größer als der ohmsche Widerstand des Strombegrenzungswiderstandselements sein. Des Weiteren kann dies das Messen des ersten elektrischen Spannungsabfalls an dem Schaltelement, das Messen des zweiten elektrischen Spannungsabfalls und das Bestimmen der ordnungsgemäßen Funktion des Schaltelements ermöglichen. Außerdem kann dies das Bereitstellen der elektrischen Mindestleistung an den Ausgängen, auch wenn das Schaltelement in den zweiten Leitungszustand abgeschaltet ist, sowie das Ausführen des Selbsttests des Garten- und/oder Forstgeräts ermöglichen.

In einer Weiterbildung der Erfindung weist das Schaltelement ein elektronisches Schaltelement auf, insbesondere einen Feldeffekttransistor, einen Bipolartransistor und/oder einen Bipolartransistor mit isolierter Gate-Elektrode (IGBT). Das elektronische Schaltelement kann ein relativ schnelles Anschalten und/oder ein relativ schnelles Abschalten ermöglichen.

In einer Ausgestaltung der Erfindung weist das Schaltelement einen Feldeffekttransistor auf. Der Feldeffekttransistor ist dazu ausgebildet, an einer Steuerelektrode mit einer Steuerspannung zum Anschalten in seinen ersten Leitungszustand und zum Abschalten in seinen zweiten Leitungszustand beaufschlagt zu werden. Die Schutzelektronikschaltung weist ein Spannungsbegrenzungselement auf. Das Spannungsbegrenzungselement ist dazu ausgebildet, die Steuerspannung derart zu erzeugen, dass kein Avalancheeffekt auftritt. Insbesondere kann das Spannungsbegrenzungselement eine Z-Diode beziehungsweise eine Zener-Diode aufweisen.

Außerdem bezieht sich die Erfindung auf ein Schutzelektronikschaltungssystem. Das erfindungsgemäße Schutzelektronikschaltungssystem weist eine Schutzelektronikschaltung wie zuvor beschrieben und eine Benutzertragevorrichtung auf. Die Schutzelektronikschaltung ist in der Benutzertragevorrichtung angeordnet. Die Benutzertragevorrichtung ist zum Tragen der Schutzelektronikschaltung durch einen Benutzer ausgebildet. Insbesondere kann die Benutzertragevorrichtung eine Gürteltasche und/oder einen Rucksack aufweisen und/oder sein. Insbesondere kann die Benutzertragevorrichtung eine Akkumulatoraufnahmeeinrichtung aufweisen, wobei die Akkumulatoraufnahmeeinrichtung zum, insbesondere auswechselbaren, Aufnehmen eines, insbesondere auswechselbaren, Akkumulators ausgebildet sein kann.

Weiter bezieht sich die Erfindung auf ein Akkumulatorsystem. Das erfindungsgemäße Akkumulatorsystem weist einen Akkumulator und eine Schutzelektronikschaltung wie zuvor beschrieben auf. Die Eingänge sind an den Akkumulator angeschlossen. Insbesondere kann der Akkumulator mit der Schutzelektronikschaltung als ein Bauteil ausgebildet sein. Insbesondere kann das Akkumulatorsystem die Benutzertragevorrichtung aufweisen.

Zudem bezieht sich die Erfindung auf ein elektrisches Garten- und/oder Forstgerätesystem. Das erfindungsgemäße elektrische Garten- und/oder Forstgerätesystem weist ein Garten- und/oder Forstgerät mit einem Elektromotor und eine Schutzelektronikschaltung wie zuvor beschrieben auf. Die Ausgänge sind an das Garten- und/oder Forstgerät angeschlossen. Insbesondere kann das Garten- und/oder Forstgerät mit der Schutzelektronikschaltung als ein Bauteil ausgebildet sein. Insbesondere kann das elektrische Garten- und/oder Forstgerätesystem die Benutzertragevorrichtung aufweisen. Insbesondere kann das elektrische Garten- und/oder Forstgerätesystem den Akkumulator aufweisen.

In einer Weiterbildung der Erfindung weist das Garten- und/oder Forstgerät eine Säge, einen Hoch-Entaster, einen Freischneider, eine Heckenschere, einen Heckenschneider, ein Blasgerät, einen Laubbläser, eine Astschere, einen Trennschleifer, ein Kehrgerät, eine Kehrwalze, eine Kehrbürste, einen Rasenmäher, einen Vertikutierer und/oder eine Grasschere auf.

### KURZBESCHREIBUNG DER ZEICHNUNGEN

Weitere Vorteile und Aspekte der Erfindung ergeben sich aus den Ansprüchen und aus der nachfolgenden Beschreibung von bevorzugten Ausführungsbeispielen der Erfindung, die nachfolgend anhand der Figuren erläutert sind. Dabei zeigen:
- Fig. 1: ein Ablaufdiagramm eines erfindungsgemäßen Verfahrens,
- Fig. 2: ein Ersatzschaltbild eines erfindungsgemäßen elektrischen Garten- und/oder Forstgerätesystems,
- Fig. 3: eine schematische Ansicht des elektrischen Garten- und/oder Forstgerätesystems der Fig. 2,
- Fig. 4: ein detailliertes Ersatzschaltbild eines Ausschnitts einer erfindungsgemäßen Schutzelektronikschaltung des elektrischen Garten- und/oder Forstgerätesystems der Fig. 2,
- Fig. 5a: einen Graph eines elektrischen Stroms durch einen Leistungspfad der Schutzelektronikschaltung der Fig. 4 über der Zeit und
- Fig. 5b: einen Graph einer elektrischen Ausgangsspannung zwischen Ausgängen der Schutzelektronikschaltung der Fig. 4 über der Zeit.

### DETAILLIERTE BESCHREIBUNG DER AUSFÜHRUNGSBEISPIELE

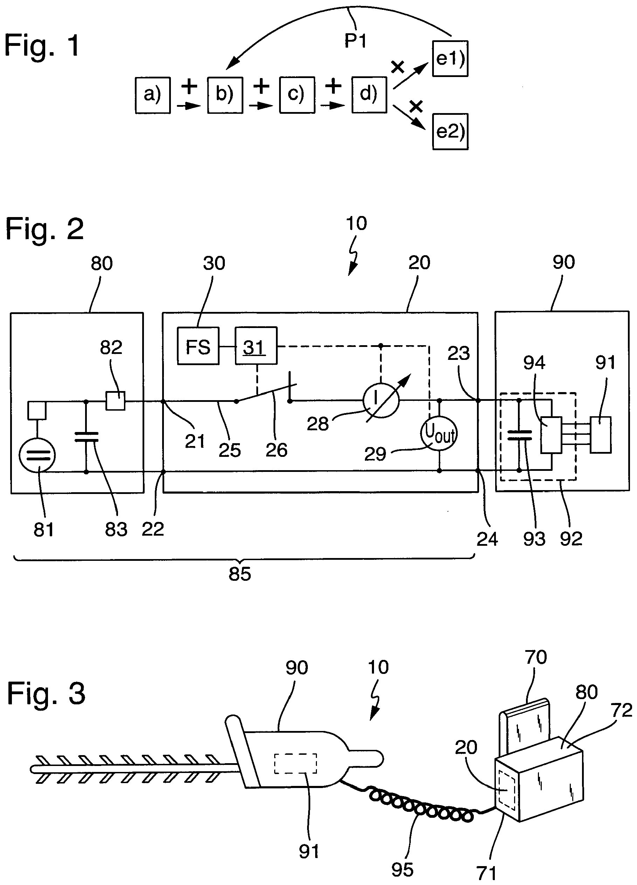

Fig. 2 und 3 zeigen ein erfindungsgemäßes elektrisches Garten- und/oder Forstgerätesystem 10. Das elektrische Garten- und/oder Forstgerätesystem weist einen Akkumulator 80, ein Garten- und/oder Forstgerät 90 in Form einer Heckenschere mit einem Elektromotor 91 und eine Schutzelektronikschaltung 20 auf. Die Schutzelektronikschaltung 20 weist Eingänge 21, 22, insbesondere zwei, Ausgänge 23, 24, insbesondere zwei, und ein Schaltelement 26 auf. Die Eingänge 21, 22 sind an den Akkumulator 80 angeschlossen. Die Ausgänge 23, 24 sind an das Garten- und/oder Forstgerät 90 angeschlossen. Das Schaltelement 26 ist in einem Leistungspfad 25 zwischen dem Eingang 21 und dem Ausgang 23 angeordnet. Insbesondere erstreckt sich der Leistungspfad 25 weiter, insbesondere zwischen dem Eingang 22 und dem Ausgang 24. Insbesondere fließt durch den Leistungspfad 25 ein elektrischer Strom I von dem Akkumulator 80 zu dem Garten- und/oder Forstgerät 90 hin und von diesem durch den Leistungspfad 25 zu dem Akkumulator 80 zurück.

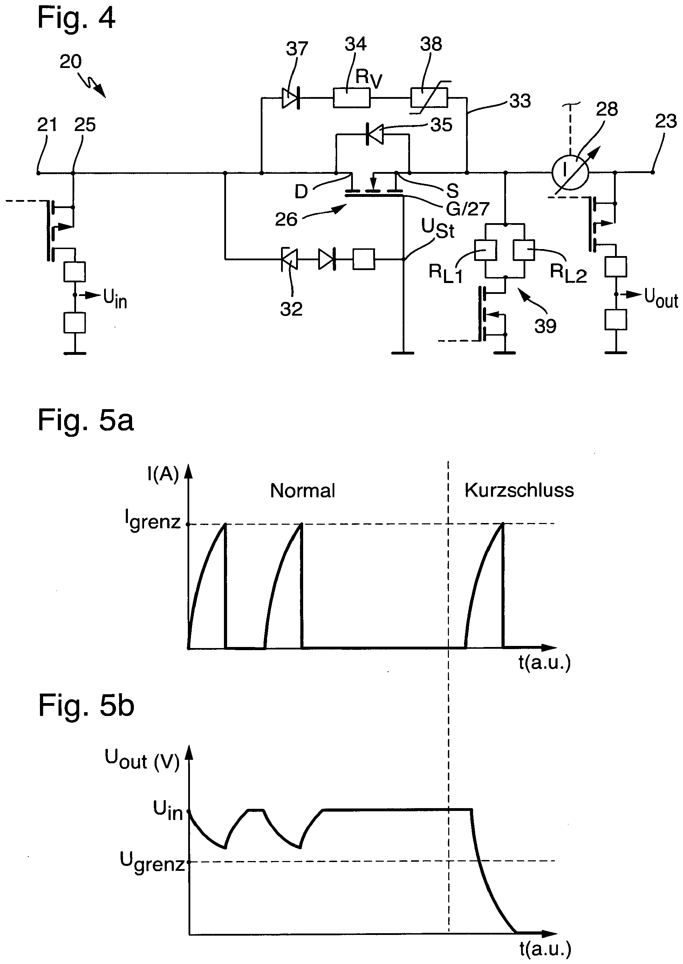

Des Weiteren weist die Schutzelektronikschaltung 20 eine Strommesseinrichtung 28, eine Spannungsmesseinrichtung 29, eine Ausgabeeinrichtung 30 und eine Steuereinheit 31 auf. Die Strommesseinrichtung 28 ist zum Messen des elektrischen Stroms I durch den Leistungspfad 25 ausgebildet. Die Spannungsmesseinrichtung 29 ist zum Messen einer elektrischen Ausgangsspannung Uout zwischen den Ausgängen 23, 24 ausgebildet. Die Ausgabeeinrichtung 30 in Form eines Summers ist zum Ausgeben eines Fehlersignals FS ausgebildet. Die Steuereinheit 31 in Form eines Mikrocontrollers ist zum Zusammenwirken mit dem Schaltelement 26, der Strommesseinrichtung 28, der Spannungsmesseinrichtung 29 und der Ausgabeeinrichtung 30 ausgebildet, wie in Fig. 2 durch gestrichelte Linien angedeutet. Des Weiteren ist die Steuereinheit 31 zum Anschalten des Schaltelements 26 in einen ersten Leitungszustand on, zum Abschalten des Schaltelements 26 in einen zweiten Leitungszustand off, falls der gemessene elektrische Strom I einen vorgegebenen Stromgrenzwert Igrenz überschreitet, wie in Fig. 5a zu erkennen, zum Wiederanschalten des Schaltelements 26 in den ersten Leitungszustand on, falls die gemessene elektrische Ausgangsspannung Uout eine vorgegeben Spannungsgrenzwert Ugrenz erreicht und/oder überschreitet, wie in Fig. 5b links zu erkennen, und zum Aktivieren der Ausgabeeinrichtung 30 zum Ausgeben des Fehlersignals FS ausgebildet, falls die gemessene elektrische Ausgangsspannung Uout den vorgegeben Spannungsgrenzwert Ugrenz unterschreitet, wie in Fig. 5b rechts zu erkennen.

Im gezeigten Ausführungsbeispiel ist die Strommesseinrichtung 28 zwischen dem in Fig. 2 oberen Eingang 21 und dem oberen Ausgang 23 angeordnet. In alternativen Ausführungsbeispielen kann die Strommesseinrichtung 28 zwischen dem in Fig. 2 unteren Eingang 22 und dem unteren Ausgang 24 angeordnet sein. Ein Abschnitt des Leistungspfads 25 zwischen dem Eingang 22 und dem Ausgang 24 kann als Massepfad bezeichnet werden.

Fig. 1 zeigt ein erfindungsgemäßes Verfahren zum Betreiben des elektrischen Garten- und/oder Forstgerätesystems 10, insbesondere mittels der zuvor beschriebenen erfindungsgemäßen Schutzelektronikschaltung 20 und/oder mittels des zuvor beschriebenen elektrischen Garten- und/oder Forstgerätesystems 10. Das Verfahren weist die Schritte auf: a) Anschalten des Schaltelements 26 in den ersten Leitungszustand on. b) Messen des elektrischen Stroms I durch den Leistungspfad 25. c) Abschalten des Schaltelements 26 in den zweiten Leitungszustand off, falls der gemessene elektrische Strom I den vorgegebenen Stromgrenzwert Igrenz überschreitet. d) Messen der elektrischen Ausgangsspannung Uout zwischen den Ausgängen 23, 24. e1) Entweder Wiederanschalten des Schaltelements 26 in den ersten Leitungszustand on, falls die gemessene elektrische Ausgangsspannung Uout den vorgegeben Spannungsgrenzwert Ugrenz erreicht und/oder überschreitet. e2) Oder Ausgeben des Fehlersignals FS, insbesondere akustisch, falls die gemessene elektrische Ausgangsspannung Uout den vorgegebenen Spannungsgrenzwert Ugrenz unterschreitet. Zusätzlich kann im Schritt e2) das Schaltelement 26 in dem zweiten Leitungszustand off behalten und/oder belassen werden.

Im Detail kann der Akkumulator 80 durch eine ideale Spannungsquelle 81, ein elektrisches Bauelement 82, insbesondere in Form einer Induktivität, und ein weiteres elektrisches Bauelement 83, insbesondere in Form eines Kondensators, beschrieben werden. Das weitere Bauelement 83 kann der Spannungsquelle 81 parallel geschaltet sein und/oder das Bauelement 82 kann in Reihe mit der Spannungsquelle 81 geschaltet sein, wie in Fig. 2 zu erkennen. Während bei einem Akkumulator älterer Bauart das Bauelement 82 in der Regel einen merklichen Einfluss auf die Charakteristik des Akkumulators hat, hat bei einem Akkumulator neuerer Bauart das Bauelement 82 in der Regel kaum noch einen Einfluss auf die Charakteristik des Akkumulators, eher das Bauelement 83. Eine Folge davon sind bei einem Akkumulator neuerer Bauart sehr kurze Stromanstiegszeiten und ein sehr hoher elektrischer Strom im Kurzschlussfall.

Im gezeigten Ausführungsbeispiel weist das Garten- und/oder Forstgerät 90 eine Motorelektronikschaltung 92 für den Elektromotor 91 auf. Die Motorelektronikschaltung 92 weist einen Zwischenkreiskondensator 93 in Form eines Elektrolytkondensators und ein Motorschaltelement 94 in Form mehrerer Brücken-Transistoren auf. Der Zwischenkreiskondensator 93 und das Motorschaltelement 94 sind jeweils an die Ausgänge 23, 24 der Schutzelektronikschaltung 20 und an den Elektromotor 91 angeschlossen.

Wenn das Schaltelement 26 in seinen ersten Leitungszustand on angeschaltet wird, der in Fig. 2 durch das Schaltelement 26 in geschlossenem Zustand angedeutet ist, kann der Akkumulator 80 mittels des elektrischen Stroms I den Zwischenkreiskondensator 93 laden. Wenn der Akkumulator 80 neuerer Bauart ist, kann der elektrische Strom I den vorgegebenen Stromgrenzwert Igrenz überschreiten, wie in Fig. 5a links zu erkennen, insbesondere verursacht von der relativ geringen Inneninduktivität 82 des Akkumulators 80 und nicht von einem elektrischen Kurzschluss. In Folge dessen wird das Schaltelement 26 in seinen zweiten Leitungszustand off abgeschaltet, der hier nicht durch das Schaltelement in geöffnetem Zustand dargestellt ist. Da kein Kurzschluss sondern Normalbetrieb vorliegt, wird die Ausgangsspannung Uout nicht unter den Spannungsgrenzwert Ugrenz sinken, wie in Fig. 5b links zu erkennen.

Wenn ein Benutzer ein in Fig. 3 gezeigtes elektrisches Kabel 95 des elektrischen Garten- und/oder Forstgerätesystem 10, das die Schutzelektronikschaltung 20 mit dem Garten- und/oder Forstgerät 90 in Form der Heckenschere elektrisch verbindet, mit der Heckenschere unvorteilhafterweise bearbeitet, kann dies zu einem elektrischem Kurzschluss in dem Kabel 95 führen, insbesondere zu einer elektrischen Kurzschlussverbindung zwischen den Ausgängen 23, 24. Wenn das Schaltelement 26 in seinen ersten Leitungszustand on angeschaltet wird oder ist, wird der elektrische Strom I den vorgegebenen Stromgrenzwert Igrenz überschreiten, wie in Fig. 5a rechts zu erkennen, insbesondere verursacht von dem Kurzschluss. In Folge dessen wird das Schaltelement 26 in seinen zweiten Leitungszustand off abgeschaltet. Da kein Normalbetrieb sondern ein Kurzschluss vorliegt, wird die Ausgangsspannung Uout unter den Spannungsgrenzwert Ugrenz sinken, insbesondere auf 0 Volt (V), wie in Fig. 5b rechts zu erkennen. Das Messen der elektrischen Ausgangsspannung Uout ermöglicht den Normalbetrieb von dem Kurzschlussfall zu unterscheiden.

Somit ermöglichen das Verfahren und die Schutzelektronikschaltung 20 jeweils, das Garten- und/oder Forstgerät 90, insbesondere dessen Motorelektronikschaltung 92, vor einem Überstrom zu schützen, den Strom I durch den Leistungspfad 25 auf ein Maß zu begrenzen, welches das Motorschaltelement 94 noch zuverlässig schalten kann, und eine Stromhöhe beim Laden des Zwischenkreiskondensators 93 zu begrenzen. Zusätzlich ermöglichen das Verfahren und die Schutzelektronikschaltung 20 jeweils, einen Überstrom aufgrund eines Kurzschlusses von einem Überstrom zu unterscheiden, welcher insbesondere von der relativ geringen Inneninduktivität 82 des Akkumulators 80 verursacht werden oder sein kann.

Des Weiteren sind das Verfahren und die Schutzelektronikschaltung 20 jeweils sowohl mit einem Akkumulator älterer Bauart als auch neuerer Bauart kompatibel, insbesondere wenn der Akkumulator als ein auswechselbarer Akkumulator ausgebildet ist. Insbesondere kann in allen Betriebsfällen ein elektrischer Strom größer als der Stromgrenzwert verhindert werden, unabhängig davon, ob die Speisung mittels eines älteren oder neueren Akkumulators erfolgt.

Im gezeigten Ausführungsbeispiel ist der vorgegebene Stromgrenzwert Igrenz 350 A. Zusätzlich stellt der Akkumulator 80 eine Eingangsspannung Uin mit einem Eingangsspannungswert zwischen den Eingängen 21, 22 bereit, wie in Fig. 4 links zu erkennen, und der vorgegebene Spannungsgrenzwert Ugrenz ist von dem Eingangsspannungswert abhängig. Insbesondere ist der Spannungsgrenzwert Ugrenz der halbe Eingangsspannungswert. Im gezeigten Ausführungsbeispiel ist der Eingangsspannungswert 36 V und der Spannungsgrenzwert Ugrenz ist 18 V.

Außerdem wird der Schritt e1) 1 ms nach dem Schritt c) ausgeführt.

Weiter werden die Schritte b) bis e1) wiederholt, wie in Fig. 1 durch den Pfeil P1 angedeutet. Insbesondere werden die Schritte b) bis e1) 10 mal ausgeführt. Falls der elektrische Strom I weiterhin den vorgegebenen Stromgrenzwert Igrenz überschreitet, kann das Schaltelement 26 in seinen zweiten Leitungszustand off abgeschaltet werden, in dem zweiten Leitungszustand off behalten werden und das Fehlersignal FS ausgegeben werden.

Zudem weist das Schaltelement 26 ein elektronisches Schaltelement in Form eines Feldeffekttransistors auf, wie in Fig. 4 zu erkennen. Der Feldeffekttransistor ist dazu ausgebildet, an einer Steuerelektrode 27 mit einer Steuerspannung Ust zum Anschalten in seinen ersten Leitungszustand on und zum Abschalten in seinen zweiten Leitungszustand off beaufschlagt zu werden. Die Schutzelektronikschaltung 20 weist ein Spannungsbegrenzungselement 32 in Form einer Z-Diode auf. Das Spannungsbegrenzungselement 32 ist dazu ausgebildet, die Steuerspannung Ust derart zu erzeugen, dass kein Avalancheeffekt auftritt. Entsprechend weist der Schritt c) auf: Erzeugen der Steuerspannung Ust derart, dass kein Avalancheeffekt auftritt. Im Detail ist das Spannungsbegrenzungselement 32 dazu ausgebildet, die Steuerspannung Ust derart zu erzeugen, dass das Schaltelement 26 in einen Linearbetrieb geschaltet wird und in seinen zweiten Leitungszustand off abgeschaltet wird. Entsprechend weist der Schritt c) auf: Schalten des Schaltelements 26 in einen Linearbetrieb und Abschalten des Schaltelements 26 in seinen zweiten Leitungszustand off. Im gezeigten Ausführungsbeispiel wird die Steuerspannung Ust in Abhängigkeit von einer Schaltspannung des Feldeffekttransistors erzeugt, welche an diesem über eine Drain (D)-Source (S)-Strecke abfällt.

Des Weiteren ist in dem Leistungspfad 25 dem Schaltelement 26 eine Freilaufdiode 35 in Sperrrichtung parallel geschaltet.

Außerdem weist die Schutzelektronikschaltung 20 einen Bypasspfad 33 auf. Der Bypasspfad 33 ist in dem Leistungspfad 25 parallel zu dem Schaltelement 26 geschaltet und weist ein Strombegrenzungswiderstandselement 34 auf. Im gezeigten Ausführungsbeispiel ist ein ohmscher Widerstand des Leistungspfads 25 von einem ohmschen Widerstand des Schaltelements 26 dominiert, wenn dieses in seinen ersten Leitungszustand on angeschaltet ist. Der ohmsche Widerstand des Leistungspfads 25 ist von einem ohmschen Widerstand des Strombegrenzungswiderstandselements 34 dominiert, wenn das Schaltelement 26 in seinen zweiten Leitungszustand off abgeschaltet ist. In anderen Worten ist der ohmsche Widerstand des Schaltelements 26, wenn dieses in seinen ersten Leitungszustand on angeschaltet ist, relativ kleiner als der ohmsche Widerstand des Strombegrenzungswiderstandselements 34. Der ohmsche Widerstand des Schaltelements 26, wenn dieses in seinen zweiten Leitungszustand off abgeschaltet ist, ist relativ größer als der ohmsche Widerstand des Strombegrenzungswiderstandselements 34. Weiter ist in dem Bypasspfad 33 in Reihe mit dem Strombegrenzungswiderstandselement 34 ein Rückschlagschutzelement 37 in Form einer Diode geschaltet. Zudem ist in dem Bypasspfad 33 in Reihe mit dem Strombegrenzungswiderstandselement 34 ein Polyswitch 38 geschaltet.

Des Weiteren weist das Verfahren die Schritte auf: Messen eines ersten elektrischen Spannungsabfalls an dem Schaltelement 26, wenn das Schaltelement 26 in seinen ersten Leitungszustand on angeschaltet ist. Messen eines zweiten elektrischen Spannungsabfalls an dem Schaltelement 26, wenn das Schaltelement 26 in seinen zweiten Leitungszustand off abgeschaltet ist. Bestimmen einer ordnungsgemäßen Funktion des Schaltelements 26 in Abhängigkeit von einer Differenz zwischen dem zweiten elektrischen Spannungsabfall und dem ersten elektrischen Spannungsabfall. Falls das Schaltelement 26 nicht ordnungsgemäß funktioniert, kann insbesondere das Fehlersignal FS ausgegeben werden. Im Detail weist die Schutzelektronikschaltung 20 eine weitere, hier nicht dargestellte Spannungsmesseinrichtung auf, welche zum Messen der elektrischen Eingangsspannung Uin zwischen den Eingängen 21, 22 ausgebildet ist. Der erste Spannungsabfall und der zweite Spannungsabfall werden mittels Messen der Eingangsspannung Uin, Messen der Ausgangsspannung Uout und Bilden einer Differenz zwischen der Eingangsspannung Uin und der Ausgangsspannung Uout gemessen. Im gezeigten Ausführungsbeispiel sollte der erste Spannungsabfall bei ordnungsgemäßer Funktion des Schaltelements 0 V betragen. Wenn das Schaltelement 26 in seinen zweiten Leitungszustand off abgeschaltet ist, sollte der zweite Spannungsabfall merklich sein, insbesondere aufgrund des Strombegrenzungswiderstandselements 34. In anderen Worten sollte die Ausgangsspannung Uout kleiner als die Eingangsspannung Uin sein, im gezeigten Ausführungsbeispiel beispielsweise anstatt 36 V 35,8V betragen. Wenn die Differenz zwischen dem zweiten elektrischen Spannungsabfall und dem ersten elektrischen Spannungsabfall einen vorgegebenen Differenzspannungsabfallsgrenzwert, beispielsweise 0,2 V = 200 mV, erreicht und/oder überschreitet, kann davon ausgegangen werden, dass das Schaltelement 26 ordnungsgemäß funktioniert. Wenn die Differenz zwischen dem zweiten elektrischen Spannungsabfall und dem ersten elektrischen Spannungsabfall den vorgegebenen Differenzspannungsabfallsgrenzwert unterschreitet, wird das Fehlersignal FS ausgegeben.

Im gezeigten Ausführungsbeispiel ist das Schaltelement 26 in Form des Feldeffekttransistors als einziges Schaltelement in dem Leistungspfad 25 zwischen einem der Eingänge 21 und einem der Ausgänge 23 angeordnet. In alternativen Ausführungsbeispielen können mehrere Schaltelemente, insbesondere mehrere elektronische Schaltelemente, insbesondere Feldeffekttransistoren, in Reihe in dem Leistungspfad zwischen einem der Eingänge und einem der Ausgänge angeordnet sein. Dies kann ermöglichen, nicht nur bei Überstrom abzuschalten, sondern auch einen Ladestrom zu unterbinden. Zusätzlich kann das Verfahren ein Bestimmen einer ordnungsgemäßen Funktion eines jeden der Schaltelemente aufweisen, wie zuvor beschrieben.

Außerdem weist das Verfahren die Schritte auf: Bereitstellen einer elektrischen Mindestleistung von dem Akkumulator 80 an den Ausgängen 23, 24, auch wenn das Schaltelement 26 in den zweiten Leitungszustand off abgeschaltet ist. Ausführen eines Selbsttests des Garten- und/oder Forstgeräts 90 unter Verwendung der bereitgestellten elektrischen Mindestleistung. Dies kann ein Bestimmen einer ordnungsgemäßen Funktion der Motorelektronikschaltung 92 ermöglichen. Im gezeigten Ausführungsbeispiel können beispielsweise 35,8 V Ausgangsspannung und ein elektrischer Strom von 2 mA bereitgestellt werden.

Weiter weist im gezeigten Ausführungsbeispiel die Schutzelektronikschaltung 20 eine Belastungsschaltung 39 auf, insbesondere für den Bypasspfad 33 mit dem Strombegrenzungswiderstandselement 34. Die Belastungsschaltung 39 kann für den Mindeststrom durch den Bypasspfad 33 beziehungsweise den Leistungspfad 25 sorgen, auch wenn das Schaltelement 26 in den zweiten Leitungszustand off abgeschaltet ist. Dadurch kann ein definierter Spannungsabfall über das Rückschlagschutzelement 37 in Form der Diode und den beziehungsweise die Widerstände im Bypasspfad 33 erzeugt werden. Insbesondere ist die Belastungsschaltung 39 an den Leitungspfad 25 zwischen dem Schaltelement 26 beziehungsweise dem Bypasspfad 33 und mindestens einem der Ausgänge 23, 24 angeschlossen.

Im Übrigen weist das elektrische Garten- und/oder Forstgerätesystem 10 eine Benutzertragevorrichtung 71 auf, wie in Fig. 3 zu erkennen. Die Schutzelektronikschaltung 20 ist in der Benutzertragevorrichtung 71 angeordnet. Die Benutzertragevorrichtung 71 in Form einer Gürteltasche ist zum Tragen der Schutzelektronikschaltung 20 durch einen Benutzer ausgebildet. Die Schutzelektronikschaltung 20 und die Benutzertragevorrichtung 71 sind Teil eines erfindungsgemäßen Schutzelektronikschaltungssystems 70 beziehungsweise bilden dieses. Des Weiteren weist die Benutzertragevorrichtung 71 eine Akkumulatoraufnahmeeinrichtung 72 auf. Die Akkumulatoraufnahmeeinrichtung 72 ist zum Aufnehmen des Akkumulators 80 ausgebildet. Außerdem sind die Schutzelektronikschaltung 20 und der Akkumulator 80 Teil eines erfindungsgemäßen Akkumulatorsystems 85 beziehungsweise bilden dieses, wie in Fig. 2 zu erkennen.

Wie die gezeigten und oben erläuterten Ausführungsbeispiele deutlich machen, stellt die Erfindung ein vorteilhaftes Verfahren zum Betreiben eines elektrischen Garten- und/oder Forstgerätesystems, das verbesserte Eigenschaften aufweist, insbesondere mehr Funktionalitäten, sowie eine Schutzelektronikschaltung für ein elektrisches Garten- und/oder Forstgerätesystem, ein Schutzelektronikschaltungssystem mit einer solchen Schutzelektronikschaltung, ein Akkumulatorsystem mit einer solchen Schutzelektronikschaltung und ein elektrisches Garten- und/oder Forstgerätesystem mit einer solchen Schutzelektronikschaltung bereit. Insbesondere ermöglichen das Verfahren und die Schutzelektronikschaltung jeweils, das Garten- und/oder Forstgerät vor einem Überstrom zu schützen und einen Überstrom aufgrund eines Kurzschlusses von einem Überstrom zu unterscheiden, welcher insbesondere von einer relativ geringen Inneninduktivität und/oder einem relativ geringen Innenwiderstand des Akkumulators verursacht werden kann.- - - - - - - - -

## Patentansprüche

1. Verfahren zum Betreiben eines elektrischen Garten- und/oder Forstgerätesystems (10), wobei das elektrische Garten- und/oder Forstgerätesystem (10) aufweist:
- einen Akkumulator (80),
- ein Garten- und/oder Forstgerät (90) mit einem Elektromotor (91) und
- eine Schutzelektronikschaltung (20), wobei die Schutzelektronikschaltung Eingänge (21, 22), welche an den Akkumulator angeschlossen sind, Ausgänge (23, 24), welche an das Garten- und/oder Forstgerät angeschlossen sind, ein Schaltelement (26), welches in einem Leistungspfad (25) zwischen einem der Eingänge und einem der Ausgänge angeordnet ist, und einen Bypasspfad (33) aufweist, welcher in dem Leistungspfad (25) parallel zu dem Schaltelement (26) geschaltet ist und ein Strombegrenzungswiderstandselement (34) aufweist,
wobei das Verfahren die Schritte aufweist:
- a) Anschalten des Schaltelements (26) in einen ersten Leitungszustand (on),
- b) Messen eines elektrischen Stroms (I) durch den Leistungspfad (25),
- c) Abschalten des Schaltelements in einen zweiten Leitungszustand (off), falls der gemessene elektrische Strom einen vorgegebenen Stromgrenzwert (Igrenz) überschreitet,
- d) Messen einer elektrischen Ausgangsspannung (Uout) zwischen den Ausgängen (23, 24) und
- e1) entweder Wiederanschalten des Schaltelements in den ersten Leitungszustand (on), falls die gemessene elektrische Ausgangsspannung einen vorgegeben Spannungsgrenzwert (Ugrenz) erreicht und/oder überschreitet,
- e2) oder Ausgeben eines Fehlersignals (FS), falls die gemessene elektrische Ausgangsspannung den vorgegeben Spannungsgrenzwert unterschreitet.

2. Verfahren nach Anspruch 1,
- wobei der vorgegebene Stromgrenzwert (Igrenz) in einem Bereich von 200 A bis 500 A liegt und/oder
- wobei der Akkumulator (80) eine Eingangsspannung (Uin) mit einem Eingangsspannungswert zwischen den Eingängen (21, 22) bereitstellt und der vorgegebene Spannungsgrenzwert (Ugrenz) von dem Eingangsspannungswert abhängig ist.

3. Verfahren nach Anspruch 1 oder 2,
- wobei der Schritt e1) in einem Bereich von 0,5 ms bis 10 ms nach dem Schritt c) ausgeführt wird.

4. Verfahren nach einem der vorhergehenden Ansprüche,
- wobei die Schritte b) bis e1) wiederholt werden.

5. Verfahren nach einem der vorhergehenden Ansprüche,
- wobei das Schaltelement (26) einen Feldeffekttransistor aufweist, welcher an einer Steuerelektrode (27) mit einer Steuerspannung (Ust) zum Anschalten in seinen ersten Leitungszustand (on) und zum Abschalten in seinen zweiten Leitungszustand (off) beaufschlagt wird,
- wobei der Schritt c) aufweist: Erzeugen der Steuerspannung (Ust) derart, dass kein Avalancheeffekt auftritt.

6. Verfahren nach einem der vorhergehenden Ansprüche,
wobei das Verfahren die Schritte aufweist:
- Messen eines ersten elektrischen Spannungsabfalls an dem Schaltelement (26), wenn das Schaltelement in seinen ersten Leitungszustand (on) angeschaltet ist,
- Messen eines zweiten elektrischen Spannungsabfalls an dem Schaltelement, wenn das Schaltelement in seinen zweiten Leitungszustand (off) abgeschaltet ist, und
- Bestimmen einer ordnungsgemäßen Funktion des Schaltelements in Abhängigkeit von einer Differenz zwischen dem zweiten elektrischen Spannungsabfall und dem ersten elektrischen Spannungsabfall.

7. Verfahren nach einem der vorhergehenden Ansprüche,
wobei das Verfahren die Schritte aufweist:
- Bereitstellen einer elektrischen Mindestleistung von dem Akkumulator (80) an den Ausgängen (23, 24), auch wenn das Schaltelement (26) in den zweiten Leitungszustand (off) abgeschaltet ist, und
- Ausführen eines Selbsttests des Garten- und/oder Forstgeräts (90) unter Verwendung der bereitgestellten elektrischen Mindestleistung.

8. Schutzelektronikschaltung (20) für ein elektrisches Garten- und/oder Forstgerätesystem (10) aufweisend:
- Eingänge (21, 22), welche zum Anschließen an einen Akkumulator (80) ausgebildet sind,
- Ausgänge (23, 24), welche zum Anschließen an ein Garten- und/oder Forstgerät (90) mit einem Elektromotor (91) ausgebildet sind,
- ein Schaltelement (26), welches in einem Leistungspfad (25) zwischen einem der Eingänge und einem der Ausgänge angeordnet ist,
- eine Strommesseinrichtung (28), welche zum Messen eines elektrischen Stroms (I) durch den Leistungspfad ausgebildet ist,
- eine Spannungsmesseinrichtung (29), welche zum Messen einer elektrischen Ausgangsspannung (Uout) zwischen den Ausgängen ausgebildet ist,
- eine Ausgabeeinrichtung (30), welche zum Ausgeben eines Fehlersignals (FS) ausgebildet ist,
- eine Steuereinheit (31), welche zum Zusammenwirken mit dem Schaltelement, der Strommesseinrichtung, der Spannungsmesseinrichtung und der Ausgabeeinrichtung und zum Anschalten des Schaltelements in einen ersten Leitungszustand (on) und zum Abschalten des Schaltelements in einen zweiten Leitungszustand (off) ausgebildet ist, falls der gemessene elektrische Strom einen vorgegebenen Stromgrenzwert (Igrenz) überschreitet,
**dadurch gekennzeichnet, dass**
- die Steuereinheit zum Wiederanschalten des Schaltelements in den ersten Leitungszustand, falls die gemessene elektrische Ausgangsspannung einen vorgegeben Spannungsgrenzwert (Ugrenz) erreicht und/oder überschreitet, und zum Aktivieren der Ausgabeeinrichtung zum Ausgeben des Fehlersignals ausgebildet ist, falls die gemessene elektrische Ausgangsspannung den vorgegeben Spannungsgrenzwert unterschreitet, und
- die Schutzelektronikschaltung (20) einen Bypasspfad (33) aufweist, welcher in dem Leistungspfad (25) parallel zu dem Schaltelement (26) geschaltet ist und ein Strombegrenzungswiderstandselement (34) aufweist.

9. Schutzelektronikschaltung (20) nach Anspruch 8,
- wobei das Schaltelement (26) ein elektronisches Schaltelement aufweist, insbesondere einen Feldeffekttransistor, einen Bipolartransistor und/oder einen Bipolartransistor mit isolierter Gate-Elektrode.

10. Schutzelektronikschaltung (20) nach Anspruch 9,
- wobei das Schaltelement (26) einen Feldeffekttransistor aufweist, welcher dazu ausgebildet ist, an einer Steuerelektrode (27) mit einer Steuerspannung (Ust) zum Anschalten in seinen ersten Leitungszustand (on) und zum Abschalten in seinen zweiten Leitungszustand (off) beaufschlagt zu werden, und
- wobei die Schutzelektronikschaltung (20) ein Spannungsbegrenzungselement (32) aufweist, welches dazu ausgebildet ist, die Steuerspannung derart zu erzeugen, dass kein Avalancheeffekt auftritt.

11. Schutzelektronikschaltungssystem (70) aufweisend:
- eine Schutzelektronikschaltung (20) nach einem der Ansprüche 8 bis 10 und
- eine Benutzertragevorrichtung (71), wobei die Schutzelektronikschaltung in der Benutzertragevorrichtung angeordnet ist und wobei die Benutzertragevorrichtung zum Tragen der Schutzelektronikschaltung durch einen Benutzer ausgebildet ist.

12. Akkumulatorsystem (85) aufweisend:
- einen Akkumulator (80) und
- eine Schutzelektronikschaltung (20) nach einem der Ansprüche 8 bis 10, wobei die Eingänge (21, 22) an den Akkumulator angeschlossen sind.

13. Elektrisches Garten- und/oder Forstgerätesystem (10) aufweisend,
- ein Garten- und/oder Forstgerät (90) mit einem Elektromotor (91) und
- eine Schutzelektronikschaltung (20) nach einem der Ansprüche 8 bis 10, wobei die Ausgänge (23, 24) an das Garten- und/oder Forstgerät angeschlossen sind.

14. Elektrisches Garten- und/oder Forstgerätesystem (10) nach Anspruch 13,
- wobei das Garten- und/oder Forstgerät (90) eine Säge, einen Hoch-Entaster, einen Freischneider, eine Heckenschere, einen Heckenschneider, ein Blasgerät, einen Laubbläser, eine Astschere, einen Trennschleifer, ein Kehrgerät, eine Kehrwalze, eine Kehrbürste, einen Rasenmäher, einen Vertikutierer und/oder eine Grasschere aufweist.

## Claims

1. A method for operating an electric gardening and/or forestry apparatus system (10), the gardening and/or forestry apparatus system (10) comprising:
- an accumulator (80),
- a gardening and/or forestry apparatus (90) having an electric motor (91), and
- a protective electronic circuit (20), the protective electronic circuit including inputs (21, 22) which are connected to the accumulator, outputs (23, 24) which are connected to the gardening and/or forestry apparatus, a switching element (26) which is disposed in a power path (25) between one of the inputs and one of the outputs, and a bypass path (33) which is coupled in the power path (25) in parallel to the switching element (26) and includes a current limiting resistor element (34),
the method comprising the steps:
- a) turning on the switching element (26) to a first conductive condition (on),
- b) measuring an electric current (I) through the power path (25),
- c) turning off the switching element to a second conductive condition (off), if the measured electric current exceeds a predetermined current limit value (Igrenz),
- d) measuring an electric output voltage (Uout) between the outputs (23, 24), and
- e1) either again turning on the switching element to the first conductive condition (on), if the measured electric output voltage reaches and/or exceeds a predetermined voltage limit value (Ugrenz),
- e2) or outputting an error signal (FS), if the measured electric output voltage is below the predetermined voltage limit value.

2. The method according to claim 1,
- wherein the predetermined current limit value (Igrenz) is in a range from 200 A to 500 A, and/or
- wherein the accumulator (80) provides an input voltage (Uin) with an input voltage value between the inputs (21, 22) and the predetermined voltage limit value (Ugrenz) is a function of the input voltage value.

3. The method according to claim 1 or 2,
- wherein the step e1) is performed in a range from 0.5 ms to 10 ms subsequent to step c).

4. The method according to any of the preceding claims,
- wherein the steps b) through e1) are repeated.

5. The method according to any of the preceding claims,
- wherein the switching element (26) includes a field effect transistor to which a control voltage (Ust) for turning on to the first conductive condition (on) thereof and for turning off to the second conductive condition (off) thereof is applied on a control electrode (27),
- wherein the step c) comprises: generating the control voltage (Ust) such that an avalanche effect does not occur.

6. The method according to any of the preceding claims,
the method comprising the steps:
- measuring a first electric voltage drop on the switching element (26), when the switching element is turned on to the first conductive condition (on) thereof,
- measuring a second electric voltage drop on the switching element, when the switching element is turned off to the second conductive condition (off) thereof, and
- determining a proper operation of the switching element as a function of a difference between the second electric voltage drop and the first electric voltage drop.

7. The method according to any of the preceding claims,
the method comprising the steps:
- providing an electric minimum power by the accumulator (80) on the outputs (23, 24), even if the switching element (26) is turned off to the second conductive condition (off), and
- performing a self-check of the gardening and/or forestry apparatus (90) using the provided electric minimum power.

8. A protective electronic circuit (20) for an electric gardening and/or forestry apparatus system (10), comprising:
- inputs (21, 22) which are configured to be connected to an accumulator (80),
- outputs (23, 24) which are configured to be connected to a gardening and/or forestry apparatus (90) having an electric motor (91),
- a switching element (26) which is disposed in a power path (25) between one of the inputs and one of the outputs,
- a current measuring device (28) which is configured to measure an electric current (I) through the power path,
- a voltage measuring device (29) which is configured to measure an electric output voltage (Uout) between the outputs,
- an output device (30) which is configured to output an error signal (FS),
- a control unit (31) which is configured to interact with the switching element, the current measuring device, the voltage measuring device and the output device and to turn on the switching element to a first conductive condition (on) and to turn off the switching element to a second conductive condition (off), if the measured electric current exceeds a predetermined current limit value (Igrenz),
**characterized in that**
- the control unit is configured to again turn on the switching element to the first conductive condition, if the measured electric output voltage reaches and/or exceeds a predetermined voltage limit value (Ugrenz), and to activate the output device to output the error signal, if the measured electric output voltage is below the predetermined voltage limit value, and
- the protective electronic circuit (20) comprises a bypass path (33) which is coupled in the power path (25) in parallel to the switching element (26) and includes a current limiting resistor element (34).

9. The protective electronic circuit (20) according to claim 8,
- wherein the switching element (26) includes an electronic switching element, in particular a field effect transistor, a bipolar transistor and/or a bipolar transistor with isolated gate electrode.

10. The protective electronic circuit (20) according to claim 9,
- wherein the switching element (26) includes a field effect transistor which is configured such that a control voltage (Ust) for turning on to the first conductive condition (on) thereof and for turning off to the second conductive condition (off) thereof is applied on a control electrode (27), and
- wherein the protective electronic circuit (20) includes a voltage limiting element (32) which is configured to generate the control voltage such that an avalanche effect does not occur.

11. A protective electronic circuit system (70), comprising:
- a protective electronic circuit (20) according to any of claims 8 to 10, and
- a user carrying device (71), wherein the protective electronic circuit is arranged in the user carrying device, and wherein the user carrying device is configured to allow carrying of the protective electronic circuit by a user.

12. An accumulator system (85), comprising:
- an accumulator (80), and
- a protective electronic circuit (20) according to any of claims 8 to 10, wherein the inputs (21, 22) are connected to the accumulator.

13. An electric gardening and/or forestry apparatus system (10), comprising:
- a gardening and/or forestry apparatus (90) having an electric motor (91), and
- a protective electronic circuit (20) according to any of claims 8 to 10, wherein the outputs (23, 24) are connected to the gardening and/or forestry apparatus.

14. The electric gardening and/or forestry apparatus system (10) according to claim 13,
- wherein the gardening and/or forestry apparatus (90) is a saw, a pole pruner, a clearing saw, a brush cutter, a hedge pruner, a blower device, a leaf blower, a lopper, a cutoff grinder, a sweeper device, a sweeper roller, a sweeper brush, a lawn mower, a dethatcher, grass shears and/or a grass trimmer.

## Revendications

1. Procédé de fonctionnement d'un système d'appareil de jardin et/ou forestier électrique (10), dans lequel le système d'appareil de jardin et/ou forestier électrique (10) comporte :
- un accumulateur (80),
- un appareil de jardin et/ou forestier (90) pourvu d'un moteur électrique (91) et
- un circuit électronique de protection (20), dans lequel le circuit électronique de protection comporte des entrées (21, 22) qui sont connectées à l'accumulateur, des sorties (23, 24) qui sont connectées à l'appareil de jardin et/ou forestier, un élément de commutation (26) qui est disposé dans un trajet de puissance (25) entre l'une des entrées et l'une des sorties, et un trajet de dérivation (33) qui est connecté en parallèle avec l'élément de commutation (26) dans le trajet de puissance (25) et qui comporte un élément de résistance de limitation de courant (34),
dans lequel le procédé comprend les étapes consistant à :
- a) activer l'élément de commutation (26) dans un premier état de conduction (on),
- b) mesurer un courant électrique (I) passant dans le trajet de puissance (25),
- c) désactiver l'élément de commutation dans un deuxième état de conduction (off) dans le cas où le courant électrique mesuré dépasse une valeur limite de courant prédéterminée (Igrenz),
- d) mesurer une tension de sortie électrique (Uout) entre les sorties (23, 24) et
- e1) soit de réactiver l'élément de commutation dans le premier état de conduction (on) dans le cas où la tension de sortie électrique mesurée atteint et/ou dépasse une valeur limite de tension prédéterminée (Ugrenz),
- e2) soit délivrer un signal d'erreur (FS) dans le cas où la tension de sortie électrique mesurée devient inférieure à la valeur limite de tension prédéterminée.

2. Procédé selon la revendication 1,
- dans lequel la valeur limite de courant prédéterminée (Igrenz) se situe dans une plage de 200 A à 500 A et/ou
- dans lequel l'accumulateur (80) fournit une tension d'entrée (Uin) présentant une valeur de tension d'entrée entre lesdites entrées (21, 22) et la valeur limite de tension prédéterminée (Ugrenz) dépend de la valeur de tension d'entrée.

3. Procédé selon la revendication 1 ou 2,
- dans lequel l'étape e1) est effectuée dans une plage de 0,5 ms à 10 ms après l'étape c).

4. Procédé selon l'une des revendications précédentes,
- dans lequel les étapes b) à e1) sont répétées.

5. Procédé selon l'une des revendications précédentes,
- dans lequel l'élément de commutation (26) comprend un transistor à effet de champ qui est soumis à une tension de commande (Ust) au niveau d'une électrode de commande (27) pour l'activer dans son premier état de conduction (on) et pour le désactiver dans son second état de conduction (off),
- dans lequel ladite étape c) consiste à : générer la tension de commande (Ust) de telle manière qu'aucun effet d'avalanche ne se produise.

6. Procédé selon l'une des revendications précédentes, dans lequel le procédé comprend les étapes consistant à :
- mesurer une première chute de tension électrique aux bornes de l'élément de commutation (26) lorsque l'élément de commutation est activé dans son premier état de conduction (on),
- mesurer une seconde chute de tension électrique aux bornes de l'élément de commutation lorsque l'élément de commutation est désactivé dans son second état de conduction (off), et
- déterminer que l'élément de commutation fonctionne correctement en fonction d'une différence entre la seconde chute de tension électrique et la première chute de tension électrique.

7. Procédé selon l'une des revendications précédentes, dans lequel le procédé comprend les étapes consistant à :
- fournir une puissance électrique minimale de l'accumulateur (80) aux sorties (23, 24) même lorsque l'élément de commutation (26) est désactivé dans le second état de conduction (off), et
- effectuer un autotest de l'appareil de jardin et/ou forestier (90) en utilisant la puissance électrique minimale fournie.

8. Circuit électronique de protection (20) destiné à un système d'appareil de jardin et/ou forestier électrique (10) comportant :
- des entrées (21, 22) qui sont conçues pour être connectées à un accumulateur (80),
- des sorties (23, 24) qui sont conçues pour être connectées à un appareil de jardin et/ou forestier (90) pourvu d'un moteur électrique (91),
- un élément de commutation (26) qui est disposé dans un trajet de puissance (25) entre l'une des entrées et l'une des sorties,
- un moyen de mesure de courant (28) qui est conçu pour mesurer un courant électrique (I) passant dans le trajet de puissance,
- un moyen de mesure de tension (29) qui est conçu pour mesurer une tension électrique de sortie (Uout) entre les sorties,
- un moyen de sortie (30) qui est conçu pour délivrer un signal d'erreur (FS),
- une unité de commande (31) qui est conçue pour coopérer avec l'élément de commutation, le moyen de mesure de courant, le moyen de mesure de tension et le moyen de sortie et pour activer l'élément de commutation dans un premier état de conduction (on) et pour désactiver l'élément de commutation dans un second état de conduction (off) dans le cas où le courant électrique mesuré dépasse une valeur limite de courant prédéterminée (Igrenz),
**caractérisé en ce que**
- l'unité de commande est conçue pour réactiver l'élément de commutation dans le premier état de conduction dans le cas où la tension de sortie électrique mesurée atteint et/ou dépasse une valeur limite de tension prédéterminée (Ugrenz), et pour activer le moyen de sortie afin de délivrer le signal d'erreur dans le cas où la tension de sortie électrique mesurée devient inférieure à la valeur limite de tension prédéterminée, et
- le circuit électronique de protection (20) comporte un trajet de dérivation (33) qui est connecté dans le trajet de puissance (25) en parallèle avec l'élément de commutation (26) et qui comporte un élément de résistance de limitation de courant (34).

9. Circuit électronique de protection (20) selon la revendication 8,
- dans lequel l'élément de commutation (26) comporte un élément de commutation électronique, en particulier un transistor à effet de champ, un transistor bipolaire et/ou un transistor bipolaire à électrode de grille isolée.

10. Circuit électronique de protection (20) selon la revendication 9,
- dans lequel l'élément de commutation (26) comporte un transistor à effet de champ qui est conçu pour être soumis à une tension de commande (Ust) au niveau d'une électrode de commande (27) pour l'activer dans son premier état de conduction (on) et pour le désactiver dans son second état de conduction (off), et
- dans lequel le circuit électronique de protection (20) comprend un élément de limitation de tension (32) qui est conçu pour générer la tension de commande de telle manière qu'aucun effet d'avalanche ne se produise.

11. Système de circuit électronique de protection (70) comportant :
- un circuit électronique de protection (20) selon l'une des revendications 8 à 10 et
- un dispositif de transport d'utilisateur (71), dans lequel le circuit électronique de protection est disposé dans le dispositif de transport d'utilisateur et dans lequel le dispositif de transport d'utilisateur est conçu pour permettre à l'utilisateur de transporter le circuit électronique de protection.

12. Système d'accumulateur (85) comportant :
un accumulateur (80) et un circuit électronique de protection (20) selon l'une des revendications 8 à 10,
dans lequel les entrées (21, 22) sont connectées à l'accumulateur.

13. Système d'appareil de jardin et/ou forestier électrique (10) comportant :
- un appareil de jardin et/ou forestier (90) pourvu d'un moteur électrique (91) et
- un circuit électronique de protection (20) selon l'une des revendications 8 à 10, dans lequel les sorties (23, 24) sont connectées à l'appareil de jardin et/ou forestier.

14. Système d'appareil de jardin et/ou forestier électrique (10) selon la revendication 13,
- dans lequel l'appareil de jardin et/ou forestier (90) comprend une scie, une perche d'élagage, une débroussailleuse, un taille-haie, un coupe-haie, un appareil de soufflage, un souffleur de feuilles, un sécateur, une tronçonneuse, un appareil de balayage, un rouleau de balayage, une brosse de balayage, une tondeuse à gazon, un scarificateur et/ou un cisaille à gazon.
